# EUROPEAN PATENT APPLICATION

(11) **EP 4 804 133 A1**
(43) Date of publication of application: **09.09.2026**
(21) Application number: 23959996.2
(22) Date of filing: 06.12.2023
(51) Int. Cl.: G06T 19/00, G06F 3/01

(54) **VIRTUAL REALITY-BASED SIMULATION METHOD AND SYSTEM FOR EXPERIENCING FALL-FROM-HEIGHT RISK AND INJURY**

(30) Priority: 29.11.2023 CN 202311614143
(71) Applicant: CSGES Operation Management Branch Company, Guangzhou, Guangdong 511400 (CN)
(72) Inventor: JI, Huaijie, Guangzhou, Guangdong 511400 (CN); LI, Xia, Guangzhou, Guangdong 511400 (CN); HE, Weijing, Guangzhou, Guangdong 511400 (CN); LI, Wei, Guangzhou, Guangdong 511400 (CN); LIU, Xin, Guangzhou, Guangdong 511400 (CN); PENG, Yuteng, Guangzhou, Guangdong 511400 (CN); ZHOU, Yuquan, Guangzhou, Guangdong 511400 (CN)
(74) Representative: Cabinet Camus Lebkiri
(86) International application number: PCT/CN2023/136825
(87) International publication number: WO 2025/112092

(57) **Abstract**

Provided in the embodiments of the present application are a virtual reality-based simulation method and system for experiencing a fall-from-height risk and injury. The method comprises: acquiring spatial structure data of a workshop of a hydropower station and power devices so as to construct a virtual reality scene of the hydropower station; constructing a character model of an operation and maintenance worker in the virtual reality scene; acquiring historical experience data of aerial working of the character model, and inputting the historical experience data into a preset risk and injury experience model so as to output weakness information of the operation and maintenance worker; establishing a training policy on the basis of the weakness information of the operation and maintenance worker, and creating a training animation in the virtual reality scene according to the training policy; the character model performing a coping operation on the basis of the training animation, so as to obtain assessment information; and, on the basis of the assessment information, determining a training result of the operation and maintenance worker. Simulating falls from heights by means of virtual reality allows operation and maintenance workers to experience risks and injuries of accidental falls during aerial working without limitations of time and space, thus improving training efficiency and safety awareness.

## Description

### TECHNICAL FIELD

The present disclosure relates to the field of high-altitude fall simulation, and in particular, to a method and a system for simulating a high-altitude fall risk injury experience based on virtual reality.

### BACKGROUND

During power plant maintenance, fall accidents are most likely to cause casualties according to accident type classification. It is not uncommon for operators to experience accidental falls. How rescue personnel can carry out rescues while ensuring their own safety is a skill that every power emergency personnel needs to master. However, considering safety issues, real-life training is difficult to conduct at high-altitude work surfaces, while simulated training makes it difficult for operators to experience a sense of presence of high-altitude work. Therefore, virtual reality (VR) fall injury experience will overcome these difficulties, enabling technicians to experience a danger of falling from a high altitude in a safe environment. In response to the above problems, an effective technical solution is urgently needed.

### SUMMARY

A purpose of the embodiments of the present disclosure is to provide a method and a system for simulating a high-altitude fall risk injury experience based on virtual reality, by constructing a highly realistic three-dimensional virtual reality scenario of a hydropower station, a danger of falling from a high altitude may be experienced in a safe environment, an operation and maintenance personnel may conduct a training of accident emergency capability in a virtual environment without being restricted by time and space, thereby improving training efficiency and safety awareness.

The embodiments of the present disclosure further provides a method for simulating a high-altitude fall risk injury experience based on virtual reality, and the method includes:
acquiring spatial structure data of a hydropower station plant and a power device to construct a virtual reality scenario of a hydropower station;
constructing a character model of an operation and maintenance personnel in the virtual reality scenario;
acquiring historical experience data of the character model for a high-altitude operation, inputting the historical experience data into a preset risk injury experience model, and outputting vulnerable information of the operation and maintenance personnel;
establishing a training strategy according to the vulnerable information of the operation and maintenance personnel, and constructing a training animation in the virtual reality scenario according to the training strategy;
performing, by the character model, a coping operation according to the training animation to obtain evaluation information;
comparing the evaluation information with preset evaluation information to obtain an evaluation value;
determining that a training of the operation and maintenance personnel is qualified, if the evaluation value is greater than or equal to a preset evaluation threshold; and
determining that the training of the operation and maintenance personnel is unqualified, if less than the evaluation threshold.

Optionally, in the method for simulating the high-altitude fall risk injury experience based on virtual reality according to the embodiments of the present disclosure, the acquiring the spatial structure data of the hydropower station plant and the power device to construct the virtual reality scenario of the hydropower station specifically includes:
acquiring a plant area and a plant structure of the hydropower station, and generating a plant virtual reality scenario in a same proportion according to the plant area and the plant structure;
calculating a dimension of the plant virtual reality scenario to obtain plant dimension information;
performing a difference calculation between the plant dimension information and preset dimension information to obtain an error value;
correcting the plant virtual reality scenario according to the error value, and establishing a virtual reality scenario coordinate system;
acquiring a structure, a distribution position, and dimension information of the power device, and establishing coordinate information of the power device;
constructing, one by one, virtual reality scenarios for a plurality of power devices according to the coordinate information of the power device to obtain a plurality of sub-scenarios; and
supplementing the plurality of sub-scenarios into the plant virtual reality scenario to obtain a global virtual reality scenario of the hydropower station.

Optionally, in the method for simulating the high-altitude fall risk injury experience based on virtual reality according to the embodiments of the present disclosure, after the constructing, one by one, the virtual reality scenarios for the plurality of power devices according to the coordinate information of the power device to obtain the plurality of sub-scenarios, the method further includes:
acquiring edge information of a sub-scenario, and performing coordinate mapping according to the edge information to obtain an edge coordinate of the sub-scenario;
comparing the edge coordinate of the sub-scenario with a preset coordinate one by one to obtain a coordinate deviation rate;
determining whether the coordinate deviation rate is greater than or equal to a preset deviation rate threshold;
generating feedback information, correspondingly modifying the edge coordinate of a corresponding sub-scenario according to the feedback information, and resetting the global virtual reality scenario of the hydropower station, if greater than or equal; and
continuing to determine the edge coordinate of a next sub-scenario, if less.

Optionally, in the method for simulating the high-altitude fall risk injury experience based on virtual reality according to the embodiments of the present disclosure, after the constructing the character model of the operation and maintenance personnel in the virtual reality scenario, the method further includes:
acquiring the character model of the operation and maintenance personnel, and identifying parameter information of the operation and maintenance personnel according to the character model to obtain a height, a weight, and contour information of the operation and maintenance personnel;
establishing character marking points based on the height, the weight, and the contour information of the operation and maintenance personnel;
calculating a center-of-gravity coordinate of a character according to the character marking points;
acquiring real-time posture information of the operation and maintenance personnel, and calculating real-time change information of the center-of-gravity coordinate of the character according to the real-time posture information of the operation and maintenance personnel to obtain a trajectory of the center-of-gravity coordinate of the character;
performing a similarity calculation between the trajectory of the center-of-gravity coordinate of the character and a preset trajectory of the center-of-gravity coordinate of the character;
determining that the posture information of the operation and maintenance personnel is normal, if the similarity is greater than a preset similarity threshold; and
determining that a posture of the operation and maintenance personnel is abnormal, and obtaining posture abnormality information, if the similarity is less than or equal to the preset similarity threshold.

Optionally, in the method for simulating the high-altitude fall risk injury experience based on virtual reality according to the embodiments of the present disclosure, the establishing the training strategy based on the vulnerable information of the operation and maintenance personnel, and constructing the training animation in the virtual reality scenario according to the training strategy specifically includes:
constructing the training animation, and generating a virtual operation interface within a preset distance according to the position information of the operation and maintenance personnel;
selecting a training category through the virtual operation interface;
setting a time window, and acquiring height information of the character model of the operation and maintenance personnel under different time windows;
performing a difference calculation on the height information of the character model of the operation and maintenance personnel under two adjacent time windows to obtain a height difference change rate;
determining that a high-altitude fall scenario occurs for the operation and maintenance personnel, and acquiring an airflow impact force on the character model, if the height difference change rate is greater than a preset height difference change rate threshold;
comparing the airflow impact force with a preset impact force threshold;
stopping a simulation of a high-altitude fall, and generating posture information of the character model during the high-altitude fall, if the airflow impact force is greater than or equal to the preset impact force threshold; and
generating a correction coefficient, and increasing a falling speed of the character model according to the correction coefficient, if the airflow impact force is less than the preset impact force threshold.

Optionally, in the method for simulating the high-altitude fall risk injury experience based on virtual reality according to the embodiments of the present disclosure, the constructing the training animation, and generating the virtual operation interface within the preset distance according to the position information of the operation and maintenance personnel includes:
acquiring parameter information of the character model of the operation and maintenance personnel, and generating head information and torso information;
analyzing a head rotation direction of the character model according to the head information to determine a forward region of the character model, and generating position information of the forward region of the character model;
generating interface adjustment information according to the position information of the forward region of the character model; and
adjusting a position of the virtual operation interface in real time according to the interface adjustment information.

In a second aspect, the embodiments of the present disclosure provides a system for simulating a high-altitude fall risk injury experience based on virtual reality. The system includes: a memory and a processor, where the memory includes a program of a method for simulating the high-altitude fall risk injury experience based on virtual reality, and the program of the method for simulating the high-altitude fall risk injury experience based on virtual reality, upon being executed by the processor, implements steps of:
acquiring spatial structure data of a hydropower station plant and a power device to construct a virtual reality scenario of a hydropower station;
constructing a character model of an operation and maintenance personnel in the virtual reality scenario;
acquiring historical experience data of the character model for a high-altitude operation, inputting the historical experience data into a preset risk injury experience model, and outputting vulnerable information of the operation and maintenance personnel;
establishing a training strategy according to the vulnerable information of the operation and maintenance personnel, and constructing a training animation in the virtual reality scenario according to the training strategy;
performing, by the character model, a coping operation according to the training animation to obtain evaluation information;
comparing the evaluation information with preset evaluation information to obtain an evaluation value;
determining that a training of the operation and maintenance personnel is qualified, if the evaluation value is greater than or equal to a preset evaluation threshold; and
determining that the training of the operation and maintenance personnel is unqualified, if less than the evaluation threshold.

Optionally, in the system for simulating the high-altitude fall risk injury experience based on virtual reality according to the embodiments of the present disclosure, the acquiring the spatial structure data of the hydropower station plant and the power device to construct the virtual reality scenario of the hydropower station specifically includes:
acquiring a plant area and a plant structure of the hydropower station, and generating a plant virtual reality scenario in a same proportion according to the plant area and the plant structure;
calculating a dimension of the plant virtual reality scenario to obtain plant dimension information;
performing a difference calculation between the plant dimension information and preset dimension information to obtain an error value;
correcting the plant virtual reality scenario according to the error value, and establishing a virtual reality scenario coordinate system;
acquiring a structure, a distribution position, and dimension information of the power device, and establishing coordinate information of the power device;
constructing, one by one, virtual reality scenarios for a plurality of power devices according to the coordinate information of the power device to obtain a plurality of sub-scenarios; and
supplementing the plurality of sub-scenarios into the plant virtual reality scenario to obtain a global virtual reality scenario of the hydropower station.

Optionally, in the system for simulating the high-altitude fall risk injury experience based on virtual reality according to the embodiments of the present disclosure, after the constructing, one by one, the virtual reality scenarios for the plurality of power devices according to the coordinate information of the power device to obtain the plurality of sub-scenarios, the steps further include:
acquiring edge information of a sub-scenario, and performing coordinate mapping according to the edge information to obtain an edge coordinate of the sub-scenario;
comparing the edge coordinate of the sub-scenario with a preset coordinate one by one to obtain a coordinate deviation rate; and
determining whether the coordinate deviation rate is greater than or equal to a preset deviation rate threshold;
generating feedback information, correspondingly modifying the edge coordinate of a corresponding sub-scenario according to the feedback information, and resetting the global virtual reality scenario of the hydropower station, if greater than or equal; and
continuing to determine the edge coordinate of a next sub-scenario, if less.

Optionally, in the system for simulating the high-altitude fall risk injury experience based on virtual reality according to the embodiments of the present disclosure, after the constructing the character model of the operation and maintenance personnel in the virtual reality scenario, the steps further include:
acquiring the character model of the operation and maintenance personnel, and identifying parameter information of the operation and maintenance personnel according to the character model to obtain a height, a weight, and contour information of the operation and maintenance personnel;
establishing character marking points based on the height, the weight, and the contour information of the operation and maintenance personnel;
calculating a center-of-gravity coordinate of a character according to the character marking points;
acquiring real-time posture information of the operation and maintenance personnel, and calculating real-time change information of the center-of-gravity coordinate of the character according to the real-time posture information of the operation and maintenance personnel to obtain a trajectory of the center-of-gravity coordinate of the character;
performing a similarity calculation between the trajectory of the center-of-gravity coordinate of the character and a preset trajectory of the center-of-gravity coordinate of the character;
determining that the posture information of the operation and maintenance personnel is normal, if the similarity is greater than a preset similarity threshold; and
determining that a posture of the operation and maintenance personnel is abnormal, and obtaining posture abnormality information, if the similarity is less than or equal to the preset similarity threshold.

As can be seen from the above, the method and the system for simulating the high-altitude fall risk injury experience based on virtual reality provided by the embodiments of the present disclosure, by acquiring spatial structure data of a hydropower station plant and a power device to construct a virtual reality scenario of a hydropower station; constructing a character model of an operation and maintenance personnel in the virtual reality scenario; acquiring historical experience data of the character model for a high-altitude operation, inputting the historical experience data into a preset risk injury experience model, and outputting vulnerable information of the operation and maintenance personnel; establishing a training strategy according to the vulnerable information of the operation and maintenance personnel, and constructing a training animation in the virtual reality scenario according to the training strategy; performing, by the character model, a coping operation according to the training animation to obtain evaluation information; comparing the evaluation information with preset evaluation information to obtain an evaluation value; determining that a training of the operation and maintenance personnel is qualified, if the evaluation value is greater than or equal to a preset evaluation threshold; and determining that the training of the operation and maintenance personnel is unqualified, if less than the evaluation threshold. In this way, by constructing a highly realistic three-dimensional virtual reality scenario of the hydropower station, a danger of falling from a high altitude may be experienced in a safe environment, the operation and maintenance personnel may conduct a training of accident emergency capability in a virtual environment without being restricted by time and space, thereby improving training efficiency and safety awareness.

Other features and advantages of the present disclosure will be expounded in the following description, and the purpose and other advantages of the present disclosure may be achieved and obtained through the structures particularly pointed out in the written description, claims, and drawings.

### BRIEF DESCRIPTION OF THE DRAWINGS

In order to illustrate the technical solutions in the embodiments of the present disclosure more clearly, the drawings required to be used in the embodiments of the present disclosure will be introduced briefly below. It should be understood that the following drawings only illustrate some embodiments of the present disclosure and therefore should not be considered as limiting the scope. For those of ordinary skill in the art, other related drawings may also be obtained based on these drawings without paying creative effort.
FIG. 1 is a flowchart of a method for simulating a high-altitude fall risk injury experience based on virtual reality provided by embodiments of the present disclosure.
FIG. 2 is a flowchart of a method for constructing a virtual reality scenario of a hydropower station in a method for simulating a high-altitude fall risk injury experience based on virtual reality provided by embodiments of the present disclosure.
FIG. 3 is a flowchart of resetting a global virtual reality scenario of a hydropower station in a method for simulating a high-altitude fall risk injury experience based on virtual reality provided by embodiments of the present disclosure.
FIG. 4 is a schematic diagram of a structure of a system for simulating a high-altitude fall risk injury experience based on virtual reality provided by embodiments of the present disclosure.

### DETAILED DESCRIPTION

The technical solutions in the embodiments of the present disclosure will be described clearly and completely below in conjunction with the accompanying drawings in the embodiments of the present disclosure. However, the described embodiments are only a part of the embodiments of the present disclosure, rather than all of the embodiments. The components of the embodiments of the present disclosure generally described and shown in the drawings herein may be arranged and designed in various different configurations. Therefore, the following detailed description of the embodiments of the present disclosure provided in the drawings is not intended to limit the scope of the claimed disclosure, but merely represents selected embodiments of the present disclosure. Based on the embodiments of the present disclosure, all other embodiments obtained by those of ordinary skill in the art without making creative effort shall belong to the protection scope of the present disclosure.

It should be noted that similar reference numerals and letters indicate similar items in the following drawings. Therefore, once an item is defined in a drawing, it does not require further definition or explanation in subsequent drawings. In addition, in the description of the present disclosure, the terms "first", "second", etc., are used for distinguishing descriptions only and cannot be construed as indicating or implying relative importance.

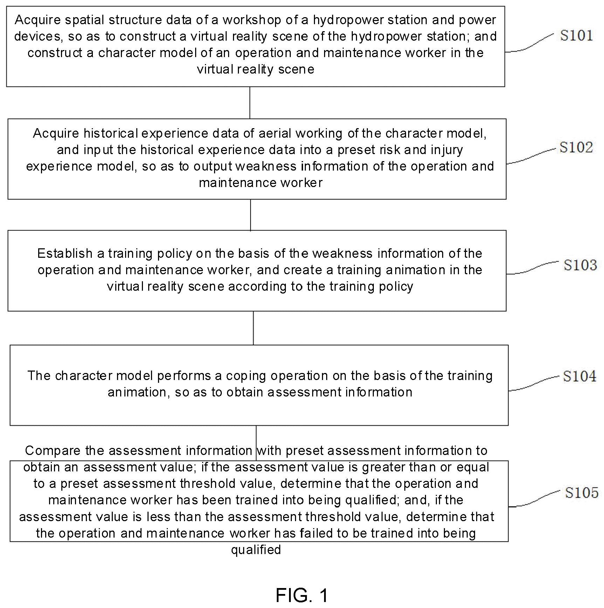

Please refer to FIG. 1, FIG. 1 is a flowchart of a method for simulating a high-altitude fall risk injury experience based on virtual reality in some embodiments of the present disclosure. The method for simulating the high-altitude fall risk injury experience based on virtual reality is applied to a terminal device. The method for simulating the high-altitude fall risk injury experience based on virtual reality at least includes S101 to S105.

In S101, spatial structure data of a hydropower station plant and a power device to construct a virtual reality scenario of a hydropower station is acquired, and a character model of an operation and maintenance personnel in the virtual reality scenario is constructed.

In S102, historical experience data of the character model for a high-altitude operation is acquired, the historical experience data is input into a preset risk injury experience model, and vulnerable information of the operation and maintenance personnel is output.

In S103, a training strategy according to the vulnerable information of the operation and maintenance personnel is established, and a training animation in the virtual reality scenario according to the training strategy is constructed.

In S104, a coping operation according to the training animation is performed, by the character model, to obtain evaluation information.

In S105, the evaluation information is compared with preset evaluation information to obtain an evaluation value; it is determined that a training of the operation and maintenance personnel is qualified, if the evaluation value is greater than or equal to a preset evaluation threshold; and it is determined that the training of the operation and maintenance personnel is unqualified, if less than the evaluation threshold.

It should be noted that by establishing a virtual reality model of a real power station to construct a virtual reality scenario of the real power station, wearing a virtual reality helmet immerses oneself in a scenario of a power station, thereby giving the operation and maintenance personnel a sense of being there. Furthermore, according to a typical high-altitude operating environment of a power plant and a record of a previous accident (actual experience of the operation and maintenance personnel), an operation flow of a character in the virtual reality environment and an animation of a device model in a virtual scenario are developed to simulate a sense of presence of an accidental fall during high-altitude operation, enabling an operator to experience a feeling of a real high-altitude fall.

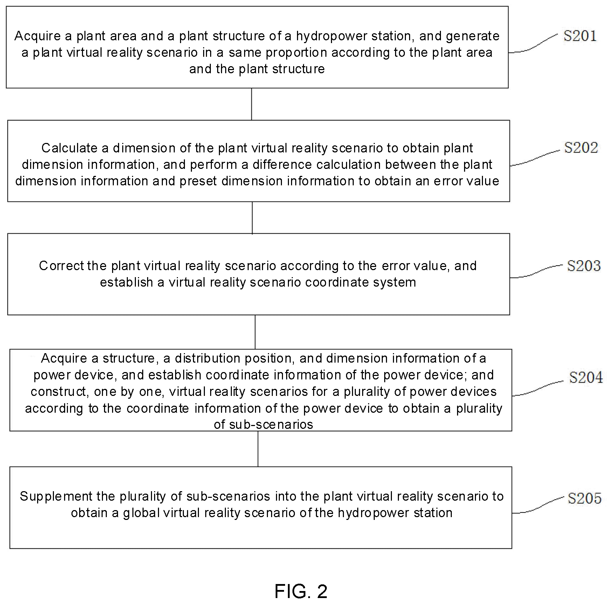

Please refer to FIG. 2, FIG. 2 is a flowchart of a method for constructing a virtual reality scenario of a hydropower station in a method for simulating a high-altitude fall risk injury experience based on virtual reality in some embodiments of the present disclosure. According to the embodiments of the present disclosure, the spatial structure data of the hydropower station plant and the power device is acquired to construct the virtual reality scenario of the hydropower station specifically at least includes S201 to S205.

In S201, a plant area and a plant structure of the hydropower station are acquired, and a plant virtual reality scenario in a same proportion according to the plant area and the plant structure is generated.

In S202, a dimension of the plant virtual reality scenario is calculated to obtain plant dimension information; a difference calculation between the plant dimension information and preset dimension information is performed to obtain an error value.

In S203, the plant virtual reality scenario is corrected according to the error value, and a virtual reality scenario coordinate system is established.

In S204, a structure, a distribution position, and dimension information of the power device are acquired, and coordinate information of the power device is established; virtual reality scenarios for a plurality of power devices, one by one, according to the coordinate information of the power device, are constructed to obtain a plurality of sub-scenarios.

In S205, the plurality of sub-scenarios are supplemented into the plant virtual reality scenario to obtain a global virtual reality scenario of the hydropower station.

It should be noted that by constructing the sub-scenarios for the plurality of power devices and supplementing the sub-scenarios one by one into the plant virtual reality scenario, an accuracy of the sub-scenarios may be accurately analyzed and determined during a sub-scenario supplementation process, thereby preventing a deviation in the virtual reality scenario and improving simulation accuracy.

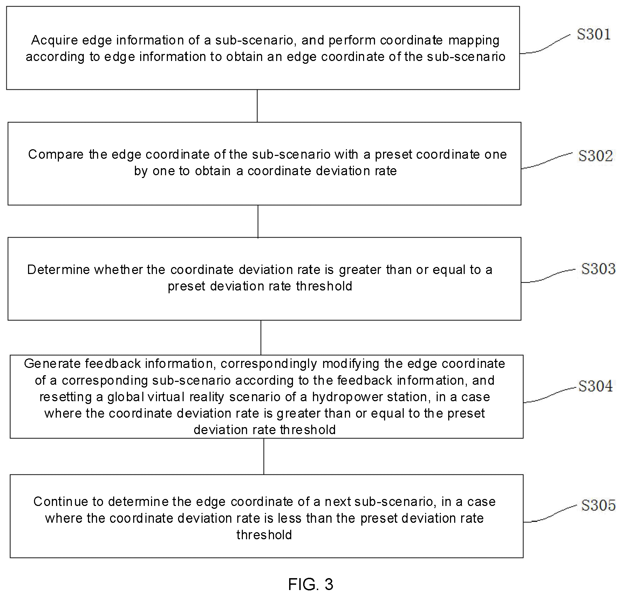

Please refer to FIG. 3, FIG. 3 is a flowchart of resetting a global virtual reality scenario of a hydropower station in a method for simulating a high-altitude fall risk injury experience based on virtual reality in some embodiments of the present disclosure. According to the embodiments of the present disclosure, after the virtual reality scenarios for the plurality of power devices, one by one, according to the coordinate information of the power device, are constructed to obtain the plurality of sub-scenarios, the method at least further includes S301 to S305.

In S301, edge information of a sub-scenario is acquired, and coordinate mapping according to the edge information is performed to obtain an edge coordinates of the sub-scenario.

In S302, the edge coordinate of the sub-scenario is compared with a preset coordinate one by one to obtain a coordinate deviation rate.

In S303, whether the coordinate deviation rate is greater than or equal to a preset deviation rate threshold is determined.

In S304, feedback information is generated, the edge coordinate of a corresponding sub-scenario according to the feedback information is correspondingly modified, and the global virtual reality scenario of the hydropower station is reset, if greater than or equal.

In S305, the edge coordinate of a next sub-scenario is continued to be determined, if less.

It should be noted that by determining the edge coordinates of the sub-scenarios, the global virtual reality scenario may be reset and updated, thereby improving an immersive effect of the global virtual reality scenario.

According to embodiments of the present disclosure, after constructing the character model of the operation and maintenance personnel in the virtual reality scenario, the method further includes:
acquiring the character model of the operation and maintenance personnel, and identifying parameter information of the operation and maintenance personnel according to the character model to obtain a height, a weight, and contour information of the operation and maintenance personnel;
establishing character marking points based on the height, the weight, and the contour information of the operation and maintenance personnel;
calculating a center-of-gravity coordinate of a character according to the character marking points;
acquiring real-time posture information of the operation and maintenance personnel, and calculating real-time change information of the center-of-gravity coordinate of the character according to the real-time posture information of the operation and maintenance personnel to obtain a trajectory of the center-of-gravity coordinate of the character;
performing a similarity calculation between the trajectory of the center-of-gravity coordinate of the character and a preset trajectory of the center-of-gravity coordinate of the character;
determining that the posture information of the operation and maintenance personnel is normal, if the similarity is greater than a preset similarity threshold; and
determining that a posture of the operation and maintenance personnel is abnormal, and obtaining posture abnormality information, if the similarity is less than or equal to the preset similarity threshold.

It should be noted that by analyzing the real-time posture information of the operation and maintenance personnel, a change of the center-of-gravity coordinate of the character of the operation and maintenance personnel is dynamically determined, thereby accurately determining an abnormal posture of the character model and analyzing the posture abnormality information of the character model to obtain an analyzing result, thus providing a reference for an operation of the operation and maintenance personnel.

According to the embodiments of the present disclosure, establishing a training strategy according to the vulnerable information of the operation and maintenance personnel, and constructing a training animation in the virtual reality scenario based on the training strategy specifically includes:
constructing the training animation, and generating a virtual operation interface within a preset distance according to position information of the operation and maintenance personnel;
selecting a training category through the virtual operation interface;
setting a time window, and acquiring height information of the character model of the operation and maintenance personnel under different time windows;
performing a difference calculation on the height information of the character model of the operation and maintenance personnel under two adjacent time windows to obtain a height difference change rate;
determining that a high-altitude fall scenario occurs for the operation and maintenance personnel, and acquiring an airflow impact force on the character model, if the height difference change rate is greater than a preset height difference change rate threshold;
comparing the airflow impact force with a preset impact force threshold;
stopping a simulation of a high-altitude fall, and generating posture information of the character model during the high-altitude fall, if the airflow impact force is greater than or equal to the preset impact force threshold; and
generating a correction coefficient, and increasing a falling speed of the character model according to the correction coefficient, if the airflow impact force is less than the preset impact force threshold.

It should be noted that by simulating the high-altitude fall scenario for the operation and maintenance personnel, and adjusting the falling speed of the operation and maintenance personnel or terminating a simulation according to a magnitude of the airflow impact force, the simulation effect and simulation realism are improved.

According to the embodiments of the present disclosure, the constructing the training animation, and generating the virtual operation interface within the preset distance according to the position information of the operation and maintenance personnel includes:
acquiring parameter information of the character model of the operation and maintenance personnel, and generating head information and torso information;
analyzing a head rotation direction of the character model according to the head information to determine a forward region (e.g., a region straight ahead) of the character model, and generating position information of the forward region of the character model;
generating interface adjustment information according to the position information of the forward region of the character model; and
adjusting a position of the virtual operation interface in real time according to the interface adjustment information.

It should be noted that in a virtual reality environment, the virtual operation interface may be placed anywhere. However, an impact of spatial layout on a perception of a user needs to be considered. Human eyes usually cannot focus on an object that is too close; a virtual operation interface that is too close is tantamount to placing a newspaper directly on a face of a person. A virtual operation interface that is too far away makes it difficult for the user to see a text prompt on the virtual operation interface clearly. A virtual operation interface that is too offset may cause fatigue due to frequent neck movements. The present disclosure adjusts a position of the virtual operation interface in real time according to a head rotation of the character model, ensuring that the virtual operation interface is always directly in front of the character model, thus improving operational comfort.

Furthermore, first, a most suitable field of view angle when a human body remains still and only eyes move to observe is calculated, as well as a most suitable field of view angle when human eyes remain still and only a head moves to observe is calculated. These angle data are integrated to determine a region seen by the human eyes under a most comfortable condition in the virtual reality environment, and the virtual operation interface is designed within this region. After repeated testing, it is ensured that all regions of the virtual operation interface are clearly visible, and that no matter how the operation and maintenance personnel moves their head, the virtual operation interface remains within a comfortable range of the character model.

According to the embodiments of the present disclosure, the determining that the high-altitude fall scenario occurs for the operation and maintenance personnel, and acquiring the airflow impact force on the character model, if the height difference change rate is greater than the preset height difference change rate threshold, further includes:
acquiring simulated heartbeat information of the character model of the operation and maintenance personnel during the high-altitude fall in real time;
comparing the simulated heartbeat information with preset heartbeat information to obtain a heartbeat deviation rate;
determining whether the heartbeat deviation rate is greater than or equal to a preset deviation rate threshold;
determining that a danger occurs, and terminating a simulation of the high-altitude fall scenario, if greater than or equal; and
monitoring a simulated heartbeat of the character model in real time, and storing heartbeat data, if less.

It should be noted that by determining the simulated heartbeat of the character model during a high-altitude fall, a change in a heartbeat of the character model may be analyzed, thereby accurately analyzing a danger of the high-altitude fall, thereby effectively preventing the operation and maintenance personnel from experiencing such a high-altitude fall situation.

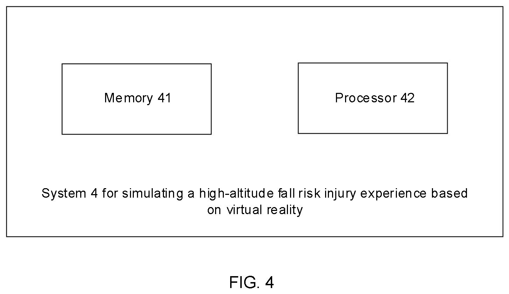

Please refer to FIG. 4, FIG. 4 is a schematic diagram of a structure of a system for simulating a high-altitude fall risk injury experience based on virtual reality in some embodiments of the present disclosure. In a second aspect, the embodiments of the present disclosure provides a system 4 for simulating a high-altitude fall risk injury experience based on virtual reality. The system includes: a memory 41 and a processor 42. The memory 41 includes a program of a method for simulating the high-altitude fall risk injury experience based on virtual reality. The program of the method for simulating the high-altitude fall risk injury experience based on virtual reality, upon being executed by the processor, implements steps of:
acquiring spatial structure data of a hydropower station plant and a power device to construct a virtual reality scenario of a hydropower station;
constructing a character model of an operation and maintenance personnel in the virtual reality scenario;
acquiring historical experience data of the character model for a high-altitude operation, inputting the historical experience data into a preset risk injury experience model, and outputting vulnerable information of the operation and maintenance personnel;
establishing a training strategy according to the vulnerable information of the operation and maintenance personnel, and constructing a training animation in the virtual reality scenario according to the training strategy;
performing, by the character model, a coping operation according to the training animation to obtain evaluation information;
comparing the evaluation information with preset evaluation information to obtain an evaluation value;
determining that a training of the operation and maintenance personnel is qualified, if the evaluation value is greater than or equal to a preset evaluation threshold; and
determining that the training of the operation and maintenance personnel is unqualified, if less than the evaluation threshold.

It should be noted that by establishing a virtual reality model of a real power station to construct a virtual reality scenario of the real power station, wearing a virtual reality helmet immerses oneself in a scenario of a power station, thereby giving the operation and maintenance personnel a sense of being there. Furthermore, according to a typical high-altitude operating environment of a power plant and a record of a previous accident (actual experience of the operation and maintenance personnel), an operation flow of a character in the virtual reality environment and an animation of device model in a virtual scenario are developed to simulate a sense of presence of an accidental fall during high-altitude operation, enabling an operator to experience a feeling of a real high-altitude fall.

According to the embodiments of the present disclosure, the acquiring the spatial structure data of the hydropower station plant and the power device to construct the virtual reality scenario of the hydropower station specifically includes:
acquiring a plant area and a plant structure of the hydropower station, and generating a plant virtual reality scenario in a same proportion according to the plant area and the plant structure;
calculating a dimension of the plant virtual reality scenario to obtain plant dimension information;
performing a difference calculation between the plant dimension information and preset dimension information to obtain an error value;
correcting the plant virtual reality scenario according to the error value, and establishing a virtual reality scenario coordinate system;
acquiring a structure, a distribution position, and dimension information of the power device, and establishing coordinate information of the power device;
constructing, one by one, virtual reality scenarios for a plurality of power devices according to the coordinate information of the power device to obtain a plurality of sub-scenarios; and
supplementing the plurality of sub-scenarios into the plant virtual reality scenario to obtain a global virtual reality scenario of the hydropower station.

It should be noted that by constructing the sub-scenarios for the plurality of power devices and supplementing the sub-scenarios one by one into the plant virtual reality scenario, an accuracy of the sub-scenarios may be accurately analyzed and determined during a sub-scenario supplementation process, thereby preventing a deviation in the virtual reality scenario and improving simulation accuracy.

According to the embodiments of the present disclosure, after the constructing, one by one, the virtual reality scenarios for the plurality of power devices according to the coordinate information of the power device to obtain the plurality of sub-scenarios, the steps further include:
acquiring edge information of a sub-scenario, and performing coordinate mapping according to the edge information to obtain an edge coordinate of the sub-scenario;
comparing the edge coordinate of the sub-scenario with a preset coordinate one by one to obtain a coordinate deviation rate;
determining whether the coordinate deviation rate is greater than or equal to a preset deviation rate threshold;
generating feedback information, correspondingly modifying the edge coordinate of a corresponding sub-scenario according to the feedback information, and resetting the global virtual reality scenario of the hydropower station, if greater than or equal; and
continuing to determine the edge coordinate of a next sub-scenario, if less.

It should be noted that by determining the edge coordinates of the sub-scenarios, the global virtual reality scenario may be reset and updated, thereby improving an immersive effect of the global virtual reality scenario.

According to the embodiments of the present disclosure, after the constructing the character model of the operation and maintenance personnel in the virtual reality scenario, the steps further include:
acquiring the character model of the operation and maintenance personnel, and identifying parameter information of the operation and maintenance personnel according to the character model to obtain a height, a weight, and contour information of the operation and maintenance personnel;
establishing character marking points based on the height, the weight, and the contour information of the operation and maintenance personnel;
calculating a center-of-gravity coordinate of a character according to the character marking points;
acquiring real-time posture information of the operation and maintenance personnel, and calculating real-time change information of the center-of-gravity coordinate of the character according to the real-time posture information of the operation and maintenance personnel to obtain a trajectory of the center-of-gravity coordinate of the character;
performing a similarity calculation between the trajectory of the center-of-gravity coordinate of the character and a preset trajectory of the center-of-gravity coordinate of the character;
determining that the posture information of the operation and maintenance personnel is normal, if the similarity is greater than a preset similarity threshold; and
determining that a posture of the operation and maintenance personnel is abnormal, and obtaining posture abnormality information, if the similarity is less than or equal to the preset similarity threshold.

It should be noted that by analyzing the real-time posture information of the operation and maintenance personnel, a change of the center-of-gravity coordinate of the character is dynamically determined, thereby accurately determining an abnormal posture of the character model and analyzing the posture abnormality information of the character model to obtain an analyzing result, thus providing a reference for an operation of the operation and maintenance personnel.

According to the embodiments of the present disclosure, the establishing the training strategy according to the vulnerable information of the operation and maintenance personnel, and constructing the training animation in the virtual reality scenario according to the training strategy specifically includes:
constructing the training animation, and generating a virtual operation interface within a preset distance according to the position information of the operation and maintenance personnel;
selecting a training category through the virtual operation interface;
setting a time window, and acquiring height information of the character model of the operation and maintenance personnel under different time windows;
performing a difference calculation on the height information of the character model of the operation and maintenance personnel under two adjacent time windows to obtain a height difference change rate;
determining that a high-altitude fall scenario occurs for the operation and maintenance personnel, and acquiring an airflow impact force on the character model, if the height difference change rate is greater than a preset height difference change rate threshold;
comparing the airflow impact force with a preset impact force threshold;
stopping a simulation of a high-altitude fall, and generating posture information of the character model during the high-altitude fall, if the airflow impact force is greater than or equal to the preset impact force threshold; and
generating a correction coefficient, and increasing a falling speed of the character model according to the correction coefficient, if the airflow impact force is less than the preset impact force threshold.

It should be noted that by simulating the high-altitude fall scenario for the operation and maintenance personnel, and adjusting the falling speed of the operation and maintenance personnel or terminating a simulation according to a magnitude of the airflow impact force, the simulation effect and simulation realism are improved.

According to the embodiments of the present disclosure, the constructing the training animation, and generating the virtual operation interface within the preset distance according to the position information of the operation and maintenance personnel includes:
acquiring parameter information of the character model of the operation and maintenance personnel, and generating head information and torso information;
analyzing a head rotation direction of the character model according to the head information to determine a forward region of the character model, and generating position information of the forward region of the character model;
generating interface adjustment information according to the position information of the forward region of the character model; and
adjusting a position of the virtual operation interface in real time according to the interface adjustment information.

It should be noted that in a virtual reality environment, the virtual operation interface may be placed anywhere. However, an impact of spatial layout on a perception of a user needs to be considered. Human eyes usually cannot focus on an object that is too close; a virtual operation interface that is too close is tantamount to placing a newspaper directly on a face of a person. A virtual operation interface that is too far away makes it difficult for the user to see a text prompt on the virtual operation interface clearly. A virtual operation interface that is too offset may cause fatigue due to frequent neck movements. The present disclosure adjusts a position of the virtual operation interface in real time according to a head rotation of the character model, ensuring that the virtual operation interface is always directly in front of the character model, thus improving operational comfort.

Furthermore, first, a most suitable field of view angle when a human body remains still and only eyes move to observe is calculated, as well as a most suitable field of view angle when human eyes remain still and only a head moves to observe is calculated. These angle data are integrated to determine a region seen by the human eyes under a most comfortable condition in the virtual reality environment, and the virtual operation interface is designed within this region. After repeated testing, it is ensured that all regions of the virtual operation interface are clearly visible, and that no matter how the operation and maintenance personnel moves their head, the virtual operation interface remains within a comfortable range of the character model.

According to the embodiments of the present disclosure, the determining that the high-altitude fall scenario occurs for the operation and maintenance personnel, and acquiring the airflow impact force on the character model, if the height difference change rate is greater than the preset height difference change rate threshold, further includes:
acquiring simulated heartbeat information of the character model of the operation and maintenance personnel during the high-altitude fall in real time;
comparing the simulated heartbeat information with preset heartbeat information to obtain a heartbeat deviation rate;
determining whether the heartbeat deviation rate is greater than or equal to a preset deviation rate threshold;
determining that a danger occurs, and terminating a simulation of the high-altitude fall scenario, if greater than or equal; and
monitoring a simulated heartbeat of the character model in real time, and storing heartbeat data, if less.

It should be noted that by determining the simulated heartbeat of the character model during a high-altitude fall, a change in a heartbeat of the character model may be analyzed, thereby accurately analyzing a danger of the high-altitude fall, thereby effectively preventing the operation and maintenance personnel from experiencing such a high-altitude fall situation.

The present disclosure discloses a method and a system for simulating a high-altitude fall risk injury experience based on virtual reality, by acquiring spatial structure data of a hydropower station plant and a power device to construct a virtual reality scenario of a hydropower station; constructing a character model of an operation and maintenance personnel in the virtual reality scenario; acquiring historical experience data of the character model for a high-altitude operation, inputting the historical experience data into a preset risk injury experience model, and outputting vulnerable information of the operation and maintenance personnel; establishing a training strategy according to the vulnerable information of the operation and maintenance personnel, and constructing a training animation in the virtual reality scenario according to the training strategy; performing, by the character model, a coping operation according to the training animation to obtain evaluation information; comparing the evaluation information with preset evaluation information to obtain an evaluation value; determining that a training of the operation and maintenance personnel is qualified, if the evaluation value is greater than or equal to a preset evaluation value; and determining that the training of the operation and maintenance personnel is unqualified, ifless than the preset evaluation value. In this way, by constructing a highly realistic three-dimensional virtual reality scenario of the hydropower station, a danger of falling from a high altitude may be experienced in a safe environment, the operation and maintenance personnel may conduct a training of accident emergency capability in a virtual environment without being restricted by time and space, thereby improving training efficiency and safety awareness.

In several embodiments provided in the present disclosure, it should be understood that the disclosed devices and methods may be implemented in other manners. The device embodiments described above are merely illustrative. For example, the division of units is only a logical function division. In actual implementation, there may be other division manners, for example, a plurality of units or components may be combined or integrated into another system, or some features may be absent or not executed. In addition, the coupling, direct coupling, or communication connection between the components shown or discussed may be indirect coupling or communication connection through some interfaces, devices, or units, and may be electrical, mechanical, or other forms.

The units described above as separate components may or may not be physically separate. The components shown as units may or may not be physical units; they may be located in a place or distributed over a plurality of network units. Some or all of the units may be selected according to actual needs to achieve a purpose of the solution of this embodiment.

In addition, each functional unit in various embodiments of the present disclosure may be fully integrated into a processing unit, or each unit may exist separately as a single unit, or two or more units may be integrated into one unit. The integrated unit mentioned above may be implemented in a form of hardware or in a form of hardware and software functional units.

Those of ordinary skill in the art may understand that all or a part of the steps of the above method embodiments may be completed by hardware related to program instructions. The aforementioned program may be stored in a readable storage medium. The program, upon being executed, executes the steps of the above method embodiments. The aforementioned storage medium includes: a mobile storage device, a read-only memory (ROM), a random access memory (RAM), a magnetic disk, an optical disk, or other various media that may store program codes.

Alternatively, if the integrated units of the present disclosure are implemented in the form of software functional modules and sold or used as standalone products, they may also be stored in a readable storage medium. Based on this understanding, the technical solution of the embodiments of the present disclosure essentially or the part that contributes to the related art may be embodied in a form of a software product, the software product is stored in a storage medium, and includes one or more instructions for enabling a computer device (which may be a personal computer, a server, or a network device, etc.) to perform all or a part of the methods described in the various embodiments of the present disclosure. The aforementioned storage medium includes: a mobile storage device, a ROM, a RAM, a magnetic disk, an optical disk, or other various media that may store program codes.

## Claims

1. A method for simulating a high-altitude fall risk injury experience based on virtual reality, comprising:
acquiring spatial structure data of a hydropower station plant and a power device to construct a virtual reality scenario of a hydropower station;
constructing a character model of an operation and maintenance personnel in the virtual reality scenario;
acquiring historical experience data of the character model for a high-altitude operation, inputting the historical experience data into a preset risk injury experience model, and outputting vulnerable information of the operation and maintenance personnel;
establishing a training strategy according to the vulnerable information of the operation and maintenance personnel, and constructing a training animation in the virtual reality scenario according to the training strategy;
performing, by the character model, a coping operation according to the training animation to obtain evaluation information;
comparing the evaluation information with preset evaluation information to obtain an evaluation value;
determining that a training of the operation and maintenance personnel is qualified, in a case where the evaluation value is greater than or equal to a preset evaluation threshold; and
determining that the training of the operation and maintenance personnel is unqualified, in a case where less than the evaluation threshold.

2. The method for simulating the high-altitude fall risk injury experience based on virtual reality according to claim 1, wherein the acquiring the spatial structure data of the hydropower station plant and the power device to construct the virtual reality scenario of the hydropower station specifically comprises:
acquiring a plant area and a plant structure of the hydropower station, and generating a plant virtual reality scenario in a same proportion according to the plant area and the plant structure;
calculating a dimension of the plant virtual reality scenario to obtain plant dimension information;
performing a difference calculation between the plant dimension information and preset dimension information to obtain an error value;
correcting the plant virtual reality scenario according to the error value, and establishing a virtual reality scenario coordinate system;
acquiring a structure, a distribution position, and dimension information of the power device, and establishing coordinate information of the power device;
constructing, one by one, virtual reality scenarios for a plurality of power devices according to the coordinate information of the power device to obtain a plurality of sub-scenarios; and
supplementing the plurality of sub-scenarios into the plant virtual reality scenario to obtain a global virtual reality scenario of the hydropower station.

3. The method for simulating the high-altitude fall risk injury experience based on virtual reality according to claim 2, wherein after the constructing, one by one, the virtual reality scenarios for the plurality of power devices according to the coordinate information of the power device to obtain the plurality of sub-scenarios, the method further comprises:
acquiring edge information of a sub-scenario, and performing coordinate mapping according to the edge information to obtain an edge coordinate of the sub-scenario;
comparing the edge coordinate of the sub-scenario with a preset coordinate one by one to obtain a coordinate deviation rate;
determining whether the coordinate deviation rate is greater than or equal to a preset deviation rate threshold;
generating feedback information, correspondingly modifying the edge coordinate of a corresponding sub-scenario according to the feedback information, and resetting the global virtual reality scenario of the hydropower station, if greater than or equal; and
continuing to determine the edge coordinate of a next sub-scenario, in a case where less.

4. The method for simulating the high-altitude fall risk injury experience based on virtual reality according to claim 3, wherein after the constructing the character model of the operation and maintenance personnel in the virtual reality scenario, the method further comprises:
acquiring the character model of the operation and maintenance personnel, and identifying parameter information of the operation and maintenance personnel according to the character model to obtain a height, a weight, and contour information of the operation and maintenance personnel;
establishing character marking points based on the height, the weight, and the contour information of the operation and maintenance personnel;
calculating a center-of-gravity coordinate of a character according to the character marking points;
acquiring real-time posture information of the operation and maintenance personnel, and calculating real-time change information of the center-of-gravity coordinate of the character according to the real-time posture information of the operation and maintenance personnel to obtain a trajectory of the center-of-gravity coordinate of the character;
performing a similarity calculation between the trajectory of the center-of-gravity coordinate of the character and a preset trajectory of the center-of-gravity coordinate of the character;
determining that the posture information of the operation and maintenance personnel is normal, in a case where the similarity is greater than a preset similarity threshold; and
determining that a posture of the operation and maintenance personnel is abnormal, and obtaining posture abnormality information, in a case where the similarity is less than or equal to the preset similarity threshold.

5. The method for simulating the high-altitude fall risk injury experience based on virtual reality according to claim 4, wherein the establishing the training strategy according to the vulnerable information of the operation and maintenance personnel, and constructing the training animation in the virtual reality scenario according to the training strategy specifically comprises:
constructing the training animation, and generating a virtual operation interface within a preset distance according to position information of the operation and maintenance personnel;
selecting a training category through the virtual operation interface;
setting a time window, and acquiring height information of the character model of the operation and maintenance personnel under different time windows;
performing a difference calculation on the height information of the character model of the operation and maintenance personnel under two adjacent time windows to obtain a height difference change rate;
determining that a high-altitude fall scenario occurs for the operation and maintenance personnel, and acquiring an airflow impact force on the character model, if the height difference change rate is greater than a preset height difference change rate threshold;
comparing the airflow impact force with a preset impact force threshold;
stopping a simulation of a high-altitude fall, and generating posture information of the character model during the high-altitude fall, in a case where the airflow impact force is greater than or equal to the preset impact force threshold; and
generating a correction coefficient, and increasing a falling speed of the character model according to the correction coefficient, in a case where the airflow impact force is less than the preset impact force threshold.

6. The method for simulating the high-altitude fall risk injury experience based on virtual reality according to claim 5, wherein the constructing the training animation, and generating the virtual operation interface within the preset distance according to the position information of the operation and maintenance personnel comprises:
acquiring parameter information of the character model of the operation and maintenance personnel, and generating head information and torso information;
analyzing a head rotation direction of the character model according to the head information to determine a forward region of the character model, and generating position information of the forward region of the character model;
generating interface adjustment information according to the position information of the forward region of the character model; and
adjusting a position of the virtual operation interface in real time according to the interface adjustment information.

7. A system for simulating a high-altitude fall risk injury experience based on virtual reality, wherein the system comprises: a memory and a processor, wherein the memory includes a program of a method for simulating the high-altitude fall risk injury experience based on virtual reality, and the program of the method for simulating the high-altitude fall risk injury experience based on virtual reality, upon being executed by the processor, implements steps of:
acquiring spatial structure data of a hydropower station plant and a power device to construct a virtual reality scenario of a hydropower station;
constructing a character model of an operation and maintenance personnel in the virtual reality scenario;
acquiring historical experience data of the character model for a high-altitude operation, inputting the historical experience data into a preset risk injury experience model, and outputting vulnerable information of the operation and maintenance personnel;
establishing a training strategy according to the vulnerable information of the operation and maintenance personnel, and constructing a training animation in the virtual reality scenario according to the training strategy;
performing, by the character model, a coping operation according to the training animation to obtain evaluation information;
comparing the evaluation information with preset evaluation information to obtain an evaluation value;
determining that a training of the operation and maintenance personnel is qualified, in a case where the evaluation value is greater than or equal to a preset evaluation threshold; and
determining that the training of the operation and maintenance personnel is unqualified, in a case where less than the evaluation threshold.

8. The system for simulating the high-altitude fall risk injury experience based on virtual reality according to claim 7, wherein the acquiring the spatial structure data of the hydropower station plant and the power device to construct the virtual reality scenario of the hydropower station specifically comprises:
acquiring a plant area and a plant structure of the hydropower station, and generating a plant virtual reality scenario in a same proportion according to the plant area and the plant structure;
calculating a dimension of the plant virtual reality scenario to obtain plant dimension information;
performing a difference calculation between the plant dimension information and preset dimension information to obtain an error value;
correcting the plant virtual reality scenario according to the error value, and establishing a virtual reality scenario coordinate system;
acquiring a structure, a distribution position, and dimension information of the power device, and establishing coordinate information of the power device;
constructing, one by one, virtual reality scenarios for a plurality of power devices according to the coordinate information of the power device to obtain a plurality of sub-scenarios; and
supplementing the plurality of sub-scenarios into the plant virtual reality scenario to obtain a global virtual reality scenario of the hydropower station.

9. The system for simulating the high-altitude fall risk injury experience based on virtual reality according to claim 8, wherein after the constructing, one by one, the virtual reality scenarios for the plurality of power devices according to the coordinate information of the power device to obtain the plurality of sub-scenarios, the steps further comprise:
acquiring edge information of a sub-scenario, and performing coordinate mapping according to the edge information to obtain an edge coordinate of the sub-scenario;
comparing the edge coordinate of the sub-scenario with a preset coordinate one by one to obtain a coordinate deviation rate;
determining whether the coordinate deviation rate is greater than or equal to a preset deviation rate threshold;
generating feedback information, correspondingly modifying the edge coordinate of a corresponding sub-scenario according to the feedback information, and resetting the global virtual reality scenario of the hydropower station, in a case where greater than or equal; and
continuing to determine the edge coordinate of a next sub-scenario, in a case where less.

10. The system for simulating the high-altitude fall risk injury experience based on virtual reality according to claim 9, wherein after the constructing the character model of the operation and maintenance personnel in the virtual reality scenario, the steps further comprise:
acquiring the character model of the operation and maintenance personnel, and identifying parameter information of the operation and maintenance personnel according to the character model to obtain a height, a weight, and contour information of the operation and maintenance personnel;
establishing character marking points based on the height, the weight, and the contour information of the operation and maintenance personnel;
calculating a center-of-gravity coordinate of a character according to the character marking points;
acquiring real-time posture information of the operation and maintenance personnel, and calculating real-time change information of the center-of-gravity coordinate of the character according to the real-time posture information of the operation and maintenance personnel to obtain a trajectory of the center-of-gravity coordinate of the character;
performing a similarity calculation between the trajectory of the center-of-gravity coordinate of the character and a preset trajectory of the center-of-gravity coordinate of the character;
determining that the posture information of the operation and maintenance personnel is normal, in a case where the similarity is greater than a preset similarity threshold; and
determining that a posture of the operation and maintenance personnel is abnormal, and obtaining posture abnormality information, in a case where the similarity is less than or equal to the preset similarity threshold.
